# DEMANDE DE BREVET EUROPEEN

(11) **EP 2 099 031 A1**
(43) Date de publication de la demande: **09.09.2009**
(21) Numéro de dépôt: 08305050.0
(22) Date de dépôt: 07.03.2008
(51) Int. Cl.: G11C 29/00, G11C 8/12, G11C 29/44, G06F 12/06, G11C 5/00, H01L 25/065

(54) **Procédés pour fabriquer un empilement de circuits mémoire et pour adresser un circuit mémoire, empilement et dispositif correspondants**

(71) Demandeur: Axalto S.A., 92190 Meudon (FR)
(72) Inventeur: Gravez, Pierre, 94130, Nogent sur Marne (FR); Thill, Michel, 78340, LES CLAYES SOUS BOIS (FR)

(57) **Abrégé**

L'invention concerne un procédé 10 pour fabriquer un empilement de circuits mémoire, le procédé comprenant une étape 14 de test de validité d'au moins deux circuits mémoire.

Selon l'invention, le procédé comprend une phase 18 de configuration de chaque circuit mémoire, la phase de configuration comportant une étape 110 d'écriture, au sein d'un dispositif de configuration de chaque circuit mémoire compris au sein de l'empilement, d'une information relative à un identifiant attribué au circuit mémoire au sein de l'empilement et d'une information relative à un résultat du test de validité du circuit mémoire.

L'invention concerne également un procédé pour adresser un circuit mémoire, un empilement de circuits mémoire et un dispositif électronique intégrant un tel empilement.

## Description

### Domaine technique de l'invention :

La présente invention concerne un procédé pour fabriquer un empilement de circuits mémoire.

La présente invention porte également sur un empilement de circuits mémoire.

La présente invention est aussi relative à un procédé pour adresser un circuit mémoire au sein d'un empilement de circuits mémoire.

Un tel empilement de circuits mémoire peut être utilisé dans de nombreux dispositifs électroniques, parmi lesquels on peut notamment citer les objets électroniques (ou « token » en langue anglaise) tels les cartes à puce, les clefs USB (acronyme pour « Universal Serial Bus » en langue anglaise), les dongles (ou « dongle » en langue anglaise).

La présente invention concerne enfin un dispositif électronique correspondant.

### Etat de la technique :

Il est connu d'utiliser, en tant que mémoire, un empilement de puces mémoire ou circuits mémoire dont la capacité mémoire correspond à la somme des capacités individuelles relatives aux différents circuits mémoire compris au sein de l'empilement.

Il est également connu d'accéder à un circuit mémoire de l'empilement depuis un microprocesseur ou une unité logique externe à l'empilement, afin soit d'écrire une nouvelle donnée à mémoriser soit de lire une donnée mémorisée au sein du circuit mémoire de l'empilement sélectionné.

Le document EP 1 736 994 décrit une solution permettant de sélectionner un circuit mémoire parmi les circuits mémoire de l'empilement.

Pour sélectionner un circuit mémoire, il est proposé d'ajouter plusieurs bits d'adresse supplémentaires. Les bits d'adresse supplémentaires sont propres à une entrée d'un circuit mémoire relative à une sélection du circuit mémoire dénommée « Chip Select ». Les entrées « Chip Select » des différents circuits mémoire sont toutes reliées électriquement entre elles. Une valeur spécifique est attribuée à l'entrée « Chip Select » de chaque circuit mémoire. Chaque circuit mémoire est alors identifié parmi l'ensemble des circuits mémoire, de manière logique, grâce à la valeur spécifique attribuée à son entrée « Chip Select ».

### Exposé de l'invention :

L'invention se propose de fournir une solution alternative à la solution de l'état de la technique décrite supra.

Plus particulièrement, l'invention est un procédé pour fabriquer un empilement de circuits mémoire. Le procédé comporte une étape de test de validité d'au moins deux circuits mémoire.

Selon l'invention, le procédé comprend une phase de configuration d'au moins un circuit mémoire, la phase de configuration comportant une étape d'écriture, au sein d'un dispositif de configuration de chaque circuit mémoire compris au sein de l'empilement, d'une information relative à un identifiant attribué au circuit mémoire au sein de l'empilement et d'une information relative à un résultat du test de validité du circuit mémoire.

Le principe général de l'invention repose sur un marquage de chaque circuit mémoire pour distinguer un circuit mémoire parmi plusieurs au sein de l'empilement et connaître son état de validité en fonctionnement avant son éventuelle utilisation.

De la sorte, lors d'un mode de configuration, un circuit mémoire composant un empilement est individuellement marqué au sein d'une partie distincte de la partie mémoire proprement dite du circuit mémoire. Puis, dans un mode de fonctionnement, chaque circuit mémoire de l'empilement identifié par son marquage est reconnu comme étant valide ou non valide en fonctionnement.

L'expression « test de validité du circuit mémoire » concerne la partie « mémoire » du circuit mémoire utilisée pour stocker une ou des données provenant de l'extérieur.

On comprend qu'un tel procédé de fabrication permet de donner un accès physique et logique à tout circuit mémoire faisant partie d'un empilement pour son éventuelle utilisation ultérieure.

Le procédé de fabrication de l'invention d'un empilement de circuits mémoire propose une solution de sélection d'un circuit mémoire parmi l'ensemble des circuits mémoire différente par rapport à la solution connue décrite supra.

On rappelle que la fabrication selon la solution connue prévoit d'écrire une valeur logique relative à l'entrée de la sélection « Chip Select » de chaque circuit mémoire, impactant la partie mémoire du circuit mémoire en tant que telle, pour être identifié au sein d'un empilement de circuits mémoire.

Selon l'invention, il est prévu d'écrire, lors de la fabrication de l'empilement, une valeur logique relative au circuit mémoire au sein d'un dispositif de configuration distinct et séparé de la partie mémoire du circuit mémoire en tant que telle.

Il convient de noter que l'empilement à circuits mémoire fabriqué selon l'invention peut comporter un ou des circuits mémoire non valides en fonctionnement.

L'invention n'impose donc aucune contrainte quant à la nature du résultat du test de validité de chaque circuit mémoire pour son utilisation au sein de l'empilement.

Par rapport à la solution connue identifiée supra, un empilement à circuits mémoire peut être fabriqué, non seulement à l'aide d'un ou plusieurs circuits mémoire valides en fonctionnement, mais aussi avec un ou plusieurs circuits mémoire non valides en fonctionnement. Contrairement à la solution de l'art antérieur, aucune matière utilisée pour produire un empilement n'est écartée et la matière, y compris celle testée comme étant non valide en fonctionnement, est exploitée pour produire un empilement. De ce fait, aucune étape de sélection de circuits mémoire valides en fonctionnement n'est mise en oeuvre pour former un empilement.

De cette manière, la fabrication d'un empilement de circuits mémoire, selon l'invention, est plus rapide et moins coûteuse à produire puisque tout circuit mémoire testé comme étant non valide n'est pas écarté.

Ainsi, le procédé de fabrication de l'invention propose une nouvelle approche pour l'identification et donc la sélection d'un circuit mémoire au sein d'un empilement tout en améliorant le rendement de production d'un empilement.

Selon un autre aspect, l'invention est un procédé pour adresser un circuit mémoire au sein d'un empilement de circuits mémoire.

Selon l'invention, le procédé comprend une étape de comparaison, au niveau d'un dispositif de configuration du circuit mémoire au sein de l'empilement, d'une information d'adresse à une information relative à un identifiant attribué au circuit mémoire au sein de l'empilement, et, dans l'hypothèse où l'information d'adresse correspond à l'information relative à l'identifiant du circuit mémoire, une étape de lecture d'une information relative à un résultat d'un test de validité du circuit mémoire.

Un circuit mémoire est repéré par un marqueur ou identifiant qui lui est propre. Le marqueur est utilisé pour identifier le circuit mémoire au sein d'un empilement duquel il fait partie.

Lorsqu'une adresse identifie un circuit mémoire particulier au sein de l'empilement du fait d'une information d'adresse correspondant, au moins en partie, à l'identifiant attribué au circuit mémoire, l'information portant sur la validité du circuit mémoire est lue.

L'information concernant la validité du circuit mémoire informe si la partie mémoire du circuit mémoire identifié par son identifiant est valide ou non, c'est-à-dire si elle est exempte de défauts ou si elle est, au contraire, défectueuse.

Enfin, l'invention est un empilement de circuits mémoire.

Plus exactement, l'empilement comporte au moins deux circuits mémoire empilés l'un sur l'autre.

Selon l'invention, chaque circuit mémoire comporte un dispositif de configuration de chaque circuit mémoire au sein de l'empilement, le dispositif de configuration comprenant des moyens pour stocker une information relative à un identifiant attribué au circuit mémoire au sein de l'empilement, et une information relative à un résultat d'un test de validité du circuit mémoire.

Il est clair que le dispositif de configuration du circuit mémoire peut être interne ou externe au circuit mémoire. Le dispositif de configuration du circuit mémoire peut constituer une partie configurable du circuit mémoire qui lui est associée lors de sa propre fabrication.

De cette manière, un circuit mémoire peut comporter, outre une partie mémoire proprement dite, une partie « configuration » au sein du circuit mémoire ou être associée à un dispositif externe au circuit, en tant que dispositif de configuration. Le dispositif de « configuration » est utilisé, d'une part, pour identifier ou repérer le circuit mémoire parmi les différents circuits mémoire composant l'empilement, et d'autre part, pour informer de l'état de fonctionnement de la partie mémoire du circuit mémoire.

On comprend donc que le dispositif de « configuration » d'un circuit mémoire est utilisée, en mode configuration, en écriture, puis, en mode fonctionnement, en lecture avant de pouvoir adresser, en lecture et/ou en écriture, la partie « mémoire » du circuit mémoire.

La validité du circuit mémoire est ou n'est pas confirmée selon que l'information portant sur la validité du circuit mémoire correspond au bon ou au mauvais fonctionnement de la partie mémoire du circuit mémoire.

### Description des dessins :

D'autres caractéristiques et avantages de l'invention apparaîtront à la lecture de la description d'un mode de réalisation préférentiel de l'invention, donné à titre de simple exemple indicatif non limitatif et des dessins annexés, dans lesquels :
- la figure 1 présente un organigramme simplifié d'un mode de réalisation d'un procédé de fabrication d'un empilement de circuits mémoire, selon l'invention ;
- la figure 2 illustre une vue schématique en coupe d'un mode de réalisation de l'empilement fabriqué à l'aide du procédé de fabrication de la figure 1 ; et
- la figure 3 présente un schéma détaillé d'un mode de réalisation d'un dispositif de configuration propre à chaque circuit mémoire prévu au sein de l'empilement de la figure 2.

### Description d'un mode de réalisation particulier de l'invention :

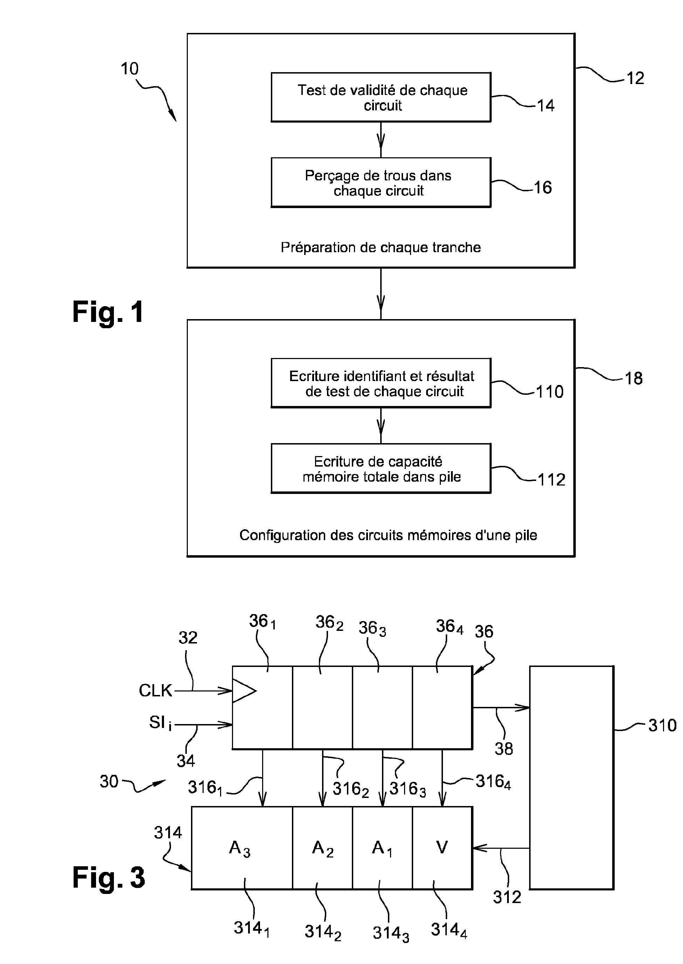

Comme montré sur la figure 1, un mode de réalisation d'un procédé 10 de fabrication d'un empilement de circuits mémoire est explicité en tant qu'exemple.

Chaque pile ou empilement de circuits mémoire est composé de circuits mémoire provenant de tranches (ou « wafer » en langue anglaise) respectives distinctes empilées l'une sur l'autre.

Une tranche est une plaque de matériau à base de silicium composée de plusieurs circuits mémoire simultanément gravés. Typiquement, une tranche comporte, selon ses dimensions et celles de chaque circuit mémoire, jusque quelques dizaines de milliers de circuits mémoire.

On peut notamment citer, comme circuits mémoire auxquels on peut appliquer le procédé 10 de fabrication explicité infra, des mémoires non volatiles des types suivants :
- EEPROM (acronyme pour « Electrically Erasable Programmable Read-Only Memory » en langue anglaise) ;
- ROM (acronyme pour « Read-Only Memory » en langue anglaise) ;
- Flash ;
- FERAM (acronyme pour « Ferroelectric Random Access Memory » en langue anglaise) ;
- MRAM (acronyme pour « Magnetoresistive Random Access Memory » en langue anglaise).

Bien entendu, une telle liste est non exhaustive.

Le procédé 10, selon le mode de réalisation présenté, comporte une phase 12 de préparation de chaque tranche destinée à être utilisée, pour former, par exemple, autant d'empilements que de circuits mémoire composent une tranche.

Les tranches à circuits mémoire utilisées pour fabriquer des empilements de circuits mémoire sont identiques, et directement superposables. Ainsi, il n'est notamment pas nécessaire d'avoir à effectuer un déplacement d'une tranche par rapport à une autre tranche pour faire coïncider des entrées et/ou des sorties correspondantes de différents circuits mémoire à accoupler.

Chaque circuit mémoire d'une tranche donnée est repéré en fonction de ses coordonnées par exemple cartésiennes au sein de la tranche concernée.

Tout d'abord, au cours de la phase 12 de préparation d'une tranche prévue, un testeur teste 14 l'ensemble des circuits mémoire de la tranche en question quant à la validité en fonctionnement de la partie mémoire de chaque circuit mémoire.

Un tel test est, par exemple, mis en oeuvre, en tout ou partie, à l'aide d'un dispositif d'autotest appelé « scan » ou « bist » connu en soi (pour « Built-in Self-Test » en langue anglaise) consistant principalement à vérifier, de manière autonome, la fonctionnalité interne du circuit mémoire intégré.

Selon une variante de réalisation, un tel test est mis en oeuvre de manière externe au circuit mémoire intégré testé, c'est-à-dire depuis un dispositif extérieur capable de générer un signal transportant une valeur prédéterminée en entrée d'au moins certaines adresses mémoire, puis, de lire, en sortie, pour chaque adresse testée, la valeur effectivement mémorisée.

Le test consiste, par exemple, à envoyer, pour chaque adresse mémoire, lors d'une écriture, en entrée du circuit mémoire concerné, une valeur de test prédéterminée selon un motif (ou « pattern » en langue anglaise) prédéterminé, et à comparer la valeur lue, pour chaque adresse concernée, à la valeur écrite. Si l'information lue correspond à l'information écrite pour chaque adresse de la zone mémoire du circuit mémoire, alors le circuit mémoire testé est valide en fonctionnement. Sinon, c'est-à-dire si au moins une information lue ne correspond pas à l'information écrite pour une adresse de la partie mémoire du circuit mémoire, alors le circuit mémoire testé est non valide en fonctionnement.

Le procédé de fabrication proposé est, par exemple, compatible avec une technologie connue et dénommée « 3D SIP » (acronyme pour « 3D System-In Package » en langue anglaise) correspondant à une technologie de production de matériau silicium d'empilement par tranche à trois dimensions. Le procédé « 3 D SIP » consiste notamment à superposer et solidariser l'empilement de tranches par alignement et scellement des tranches.

Une tranche représente un seul étage d'autant d'empilements que de circuits mémoire qui composent la tranche.

Lorsque le circuit mémoire testé est valide, c'est-à-dire bon en fonctionnement, il lui est attribué une valeur prédéterminée codée sur un bit, par exemple la valeur « un ».

Lorsque le circuit mémoire testé est non valide, c'est-à-dire mauvais en fonctionnement, il lui est attribué une autre valeur prédéterminée codée sur un bit, par exemple la valeur « zéro ».

Un tel test par tranche est répété sur autant de tranches que de circuits mémoire qui doivent composer un empilement.

A la fin du test de tous les circuits mémoire de la tranche, le testeur mémorise une image électrique propre à la tranche concernée de tous les résultats de validité correspondants. Pour ce faire, le testeur utilisé dispose dans une mémoire interne au testeur ou dans une mémoire externe accessible depuis le testeur, pour chaque tranche identifiée, des coordonnées cartésiennes des circuits mémoire bons et mauvais en fonctionnement.

L'image électrique mémorisée identifie la caractéristique valide ou non valide de chaque circuit mémoire associée aux coordonnées cartésiennes d'un circuit mémoire quelconque au sein de la tranche considérée et identifiée au sein d'une mémoire du testeur ou d'une mémoire reliée au testeur.

Suite aux tests des différentes tranches, le testeur stocke en mémoire interne ou dans une mémoire à laquelle le testeur peut accéder, une image électrique en trois dimensions (ou 3D) de l'état de chaque circuit mémoire de l'ensemble des tranches testées et identifiées par un numéro du rang de construction au sein de l'empilement à réaliser.

L'image électrique 3D représentée, par exemple sous la forme d'un journal de données de correspondance électronique (ou « E-mapping datalog » en langue anglaise), est compatible avec des équipements de test connus. Ainsi, il n'est pas nécessaire d'adapter l'image électrique 3D résultante pour pouvoir l'exploiter par la suite, pour configurer les circuits mémoire de chaque empilement.

Puis, pour chaque tranche testée, au cours de la phase 12 de préparation, lors d'une étape suivante 16 de perçage de ses circuits mémoire, un trou est formé au niveau de chaque plot de connexion de la partie mémoire, pour une partie relative à des données (ou « data » en langue anglaise), pour une partie relative à des adresses (ou « address » en langue anglaise), pour une entrée relative à une sélection du circuit mémoire (ou « Chip select » en langue anglaise), et pour au moins deux bornes pour alimenter le circuit mémoire.

Au cours de l'étape 16 de perçage, un trou est également formé, au niveau d'un dispositif de configuration prévu sur chaque circuit mémoire, au niveau d'une ou plusieurs entrées relatives à une information propre à un identifiant à attribuer au circuit mémoire au sein de l'empilement à former.

De manière optionnelle, toujours au cours de l'étape 16 de perçage, un trou est également formé, au niveau du dispositif d'autotest, en fonction du rang physique de la tranche prévu au sein de l'empilement en cours de réalisation. En d'autres termes, les trous au niveau de chaque dispositif d'autotest sont codés en fonction de la position du circuit mémoire au sein de l'empilement à réaliser.

Le dispositif de configuration de chaque circuit mémoire permet de sélectionner le circuit mémoire auquel le dispositif de configuration est associé.

Le ou les trous ainsi formés permettent de donner un accès physique au dispositif de configuration relatif à chaque circuit mémoire des tranches impliquées dans la formation d'empilements.

Le dispositif de configuration est, par exemple, interne au circuit mémoire. Le dispositif de configuration correspond avantageusement à un matériel configurable prévu lors de la fabrication de chaque circuit mémoire au sein d'une tranche.

De même, toujours au cours de l'étape 16 de perçage, un trou est aussi formé, au niveau du dispositif de configuration prévu sur chaque circuit mémoire, au niveau d'une ou plusieurs entrées pour une information propre au résultat du test de validité du circuit mémoire en question.

Selon une variante de réalisation non représentée, l'étape de perçage des circuits mémoire compris au sein de la tranche précède l'étape de test des circuits mémoire de la tranche.

Une fois les circuits mémoire de chaque tranche préparés, à savoir testés puis percés, on passe à au moins certaines des phases (non représentées) suivantes relatives à la formation des empilements :
- une phase de superposition de circuits mémoire de différentes tranches préparées faisant coïncider des trous traversant formés au sein de la partie mémoire, et certains trous traversant formés au sein de la partie configuration de circuits mémoire à empiler l'un sur l'autre ;
- une phase de solidarisation des tranches préparées, consistant, par exemple, à appliquer de la colle entre les tranches à solidariser ;
- une phase de remplissage, à l'aide de matériau électriquement conducteur, tel un métal à base de silicium, des trous traversant et de trous non traversant relatifs aux parties mémoire et configuration des circuits mémoire accessibles depuis la tranche la plus haute ;
- une phase de test de continuité électrique au travers d'un autotest câblé selon un décodage d'adresse physique de la tranche au sein de l'empilement.

La préparation des tranches impliquées pour la formation d'empilements terminée complétée par au moins une des phases précitées, on passe à une phase 18 de configuration de chaque circuit mémoire d'un empilement, et ce pour chaque empilement.

Selon l'invention, la phase 18 de configuration comporte une étape 110 d'écriture, au sein du dispositif de configuration de chaque circuit mémoire compris au sein de l'empilement, d'une part, d'une information relative à un identifiant attribué au circuit mémoire au sein de l'empilement, et, d'autre part, d'une information relative à un résultat du test de validité du circuit mémoire.

Les entrées de la partie mémoire du circuit mémoire ne sont pas affectées par une quelconque écriture lors de la phase de configuration. Seul, le dispositif de configuration du circuit mémoire, en tant que partie distincte de la partie mémoire du circuit mémoire, est impacté lors de la phase de configuration.

L'écriture en elle-même des informations concernées peut être mise en oeuvre par programmation, par exemple, sous forme d'un mot d'état.

Les informations relatives aux identifiants attribués aux différents circuits mémoire de chaque empilement sont fournies grâce à l'image électrique 3D mémorisée au sein de la mémoire interne du testeur ou dans la mémoire externe accessible depuis le testeur.

De même, les informations relatives aux résultats du test de validité de chaque circuit mémoire sont fournies grâce à l'image électrique 3D mémorisée au sein de la mémoire interne du testeur ou dans la mémoire externe accessible depuis le testeur.

De cette manière, chaque circuit mémoire employé au sein d'un empilement est identifiable, et ce qu'il ait été testé comme étant valide ou non valide en fonctionnement. Lorsqu'un circuit mémoire est sélectionné par son identifiant parmi l'ensemble des circuits mémoire de l'empilement, le circuit mémoire sélectionné est caractérisé par son état de validité en fonctionnement.

Selon une telle fabrication d'un empilement de circuits mémoire, soit une partie interne de chaque circuit mémoire distincte de la partie mémoire proprement dite soit une partie externe de chaque circuit mémoire tout en étant associée au circuit mémoire est modifiée. Ainsi, la partie mémoire de chaque circuit mémoire est conservée et n'est donc pas modifiée ni selon un aspect matériel ni selon un aspect logiciel.

Une fois que l'écriture des informations propres aux identifiants des circuits mémoire et aux résultats des tests de leurs validités respectives a été effectuée pour chaque empilement, on procède à une étape 112 ultérieure d'écriture d'une information relative à la capacité mémoire totale relative à l'ensemble des circuits valides au sein de l'empilement concerné.

Lors d'une telle étape 112, il est procédé à l'écriture, au sein d'une adresse mémoire prédéterminée, du premier circuit mémoire compris au sein de l'empilement et dont le résultat du test de validité correspond à un état valide en fonctionnement, d'une information relative à une capacité mémoire totale propre à l'ensemble des circuits mémoire compris au sein de l'empilement et dont le résultat individuel du test de validité correspond à un état valide en fonctionnement. L'adresse mémoire de l'empilement est, par exemple, la première adresse accessible de l'empilement de circuits mémoire ainsi configurés, en tant que signature électronique propre à l'empilement.

Une fois la phase de configuration effectuée, on peut passer à une phase de découpe des tranches (non représentée), de façon à dissocier les empilements de circuits mémoire ainsi configurés.

On rappelle qu'un seul circuit mémoire testé non valide en fonctionnement au sein d'un empilement rend l'empilement défectueux si l'on n'interdit pas son accès.

Les circuits mémoire d'un empilement testés non valides en fonctionnement sont interdits en accès lors de leurs configurations et, de ce fait, « invalidés » pour toute tentative d'accès ultérieur.

Le rendement de production des empilements est avantageusement amélioré.

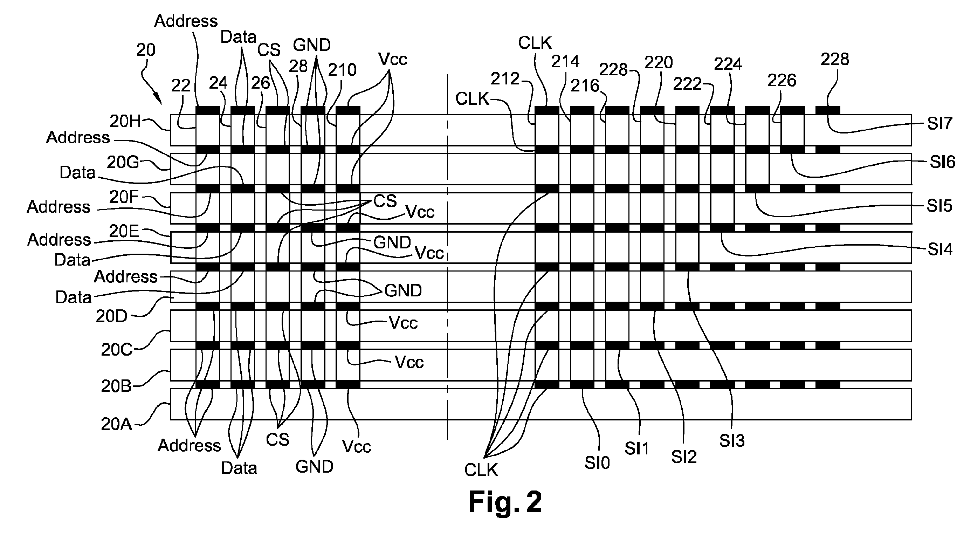

Un empilement 20 de huit circuits mémoire 20A, 20B, 20C, 20D, 20E, 20F, 20G, 20H selon un exemple résultant du procédé de fabrication détaillé ci-dessus est maintenant explicité en relation avec la figure 2.

La figure 2 représente, de manière schématique, l'empilement 20 résultant.

Il est clair que l'invention peut être rendue conforme à tous les standards existants ou à venir.

Parmi les standards actuels, on peut notamment citer un standard dit JEDEC (acronyme pour « Joint Electron Device Engineering Council » en langue anglaise) d'adressage des mémoires « Nand » depuis l'extérieur.

Selon le standard JEDEC connu en soi, il est prévu un bus de huit entrées/sorties (ou « Input/Output data/address » en langue anglaise) multiplexant les données et adresses correspondantes, une entrée de sélection du circuit mémoire (ou « Chip Select » ayant pour acronyme « CS » ou « Chip Enable » ayant pour acronyme « CE » en langue anglaise), six plots d'entrée relatifs à une logique de contrôle, à savoir un plot d'autorisation de lecture (ou « Read Enable » ayant pour acronyme « RE » en langue anglaise), un plot d'autorisation d'écriture (ou « Write Enable » ayant pour acronyme « WE » en langue anglaise), un plot de protection en écriture (ou « Write Protect » ayant pour acronyme « WP » en langue anglaise), un plot d'information prêt/occupé (ou « Ready Busy » ayant pour acronyme « WE » en langue anglaise), un plot d'autorisation verrouillée d'adresse (ou « Address Latch Enable » ayant pour acronyme « ALE » en langue anglaise), un plot d'autorisation verrouillée de commande (ou « Command Latch Enable » ayant pour acronyme « CLE » en langue anglaise), et quatre plots relatifs à l'alimentation dont deux pour la terre (ou « GND ») et deux pour la tension d'alimentation (ou « Vcc »).

A titre indicatif, la tension d'alimentation peut être égale à 5 Volts, 3 Volts, ou 1,8 Volts. Bien entendu, la tension d'alimentation n'est pas restreinte à ces seules valeurs.

L'empilement 20 de circuits mémoire 20A, 20B, 20C, 20D, 20E, 20F, 20G ou 20H est, avantageusement, issu d'une découpe de plusieurs tranches de circuits mémoire respectives.

Chaque circuit mémoire 20A, 20B, 20C, 20D, 20E, 20F, 20G ou 20H résulte d'une découpe d'une tranche et constitue un étage de l'empilement 20.

La partie située à gauche du trait en pointillé représenté sur la figure 2 correspond, pour chaque circuit mémoire 20A, 20B, 20C, 20D, 20E, 20F, 20G ou 20H, à la partie fonctionnelle du circuit mémoire concerné, à savoir la partie mémoire proprement dite.

La partie mémoire de chaque circuit mémoire comporte, sauf pour le circuit mémoire 20A situé en bas de l'empilement, des trous 22, 24, 26, 28 et 210 traversant en regard de chaque plot de connexion constituant une entrée, à savoir:
- une entrée « Address » propre à un bus d'adresse,
- une entrée « data » propre à un bus de données,
- une entrée « CS » (pour « Chip Select » en langue anglaise) propre à une sélection du circuit mémoire concerné,
- une entrée « GND » propre à une première borne d'alimentation du circuit mémoire concerné, par exemple de 0 Volt, et
- une entrée « Vcc » propre à une deuxième borne d'alimentation du circuit mémoire concerné.

Les entrées « Address », « data », « CS », « GND », et « Vcc » de la partie mémoire du circuit mémoire 20H supérieur sont reliées électriquement aux entrées correspondantes de chaque circuit mémoire 20A, 20B, 20C, 20D, 20E, 20F et 20G qui se situe sous le circuit mémoire 20 H supérieur.

Les entrées de la partie mémoire des circuits mémoire 20A, 20B, 20C, 20D, 20E, 20F, 20G et 20H sont réunies pour former une seule et même entité mémoire avec une unique entrée commune « CS » pour l'empilement ainsi constitué. La valeur logique affectée à l'entrée commune « CS » est unique.

La valeur logique d'un circuit mémoire à sélectionner au sein de l'empilement à l'aide de son entrée « CS » n'est donc pas modifiée, contrairement à la solution connue.

La partie située à droite du trait en pointillé correspond, pour chaque circuit mémoire 20A, 20B, 20C, 20D, 20E, 20F, 20G ou 20H, à une partie relative à un dispositif de configuration du circuit mémoire concerné.

Chaque circuit mémoire de l'empilement 20 est référencé par une valeur correspondant avantageusement à son rang au sein de l'empilement. Ainsi, le circuit mémoire 20H supérieur de l'empilement 20 correspond, par exemple, au circuit mémoire référencé par la valeur « 7 » correspondant, en binaire, à la valeur « 111 », sur les huit circuits mémoire. Le circuit mémoire 20A inférieur de l'empilement 20 correspond, par exemple, au circuit mémoire référencé par la valeur « 0 » correspondant en binaire à la valeur « 000 ».

Sept circuits mémoire 20B, 20C, 20D, 20E, 20F, 20G, et 20H comportent, au niveau de leur dispositif de configuration respectif, au moins un trou, (suite à l'étape 16 de perçage du circuit mémoire), au niveau d'au moins une entrée partagée et/ou dédiée, d'une part, à l'identifiant attribué au circuit mémoire concerné au sein de l'empilement, et d'autre part, à l'information relative au résultat du test de validité du circuit mémoire.

Les trous percés au niveau des dispositifs de configuration sont en relation avec le rang occupé par chaque circuit mémoire au sein de l'empilement 20.

Les différentes entrées sont présentées plus en détails en relation avec la figure 3 décrite plus bas.

Une première entrée propre à un signal d'horloge « CLK » est commune, dans le présent exemple, à tous les dispositifs de configuration de l'ensemble des circuits mémoire 20A, 20B, 20C, 20D, 20E, 20F, 20G et 20H.

Ainsi, le circuit mémoire 20H supérieur comporte, au niveau de son dispositif de configuration (détaillé en relation avec la figure 3), des trous 212, 214, 216, 218, 220, 222, 224, et 226, et une borne 228 d'entrée électriquement conductrice. Les trous 212, 214, 216, 218, 220, 222, 224, et 226 permettent un accès physique à au moins une entrée partagée et/ou dédiée à l'information relative à l'identifiant attribué à un circuit mémoire situé sous le circuit mémoire 20H au sein de l'empilement et au moins une entrée partagée et/ou dédiée à l'information relative au résultat du test de validité du circuit mémoire sous le circuit mémoire 20H.

Par exemple, le circuit mémoire 20A d'un premier étage au sein de l'empilement 20 ne comprend aucun trou tout en ayant deux entrées accessibles depuis le haut de l'empilement, l'une propre au signal d'horloge « CLK », et l'autre relative à son entrée série « SI0 » (pour « Serial Input number 0 »). Ces deux entrées CLK et SI0 sont nécessaires pour configurer le dispositif de configuration du circuit mémoire 20A inférieur. Plus précisément, l'entrée CLK est utilisée pour fournir le signal d'horloge au dispositif de configuration. L'entrée SI0 est utilisée pour pouvoir paramétrer, d'une part, l'identifiant attribué au circuit mémoire 20A du premier étage, et d'autre part, le résultat du test de validité du circuit mémoire 20A du premier étage.

Le circuit mémoire 20B d'un deuxième étage au sein de l'empilement 20 comprend deux trous pour relier, depuis le haut de l'empilement 20, les deux entrées relatives au signal d'horloge CLK et à l'entrée série 0 SI0 du circuit mémoire 20A du premier étage, et trois entrées relatives au signal d'horloge CLK, à l'entrée série 0 SI0, et à une entrée série 1 « SI1 » pour configurer le dispositif de configuration du circuit mémoire 20B du deuxième étage.

Le circuit mémoire 20C d'un troisième étage au sein de l'empilement 20 comporte trois trous pour relier, depuis le haut de l'empilement 20, les trois entrées CLK, SI0 et SI1 du circuit mémoire 20B du deuxième étage, et quatre entrées relatives au signal d'horloge CLK, aux entrées série SI0 et SI1, et à une entrée série 2 « SI2 » pour configurer le dispositif de configuration du circuit mémoire 20C du troisième étage.

Et ce, de même jusqu'au circuit mémoire 20H du huitième et dernier étage au sein de l'empilement 20, le circuit mémoire 20H supérieur comporte huit trous pour accéder physiquement, depuis le haut de l'empilement 20, à huit entrées CLK, SI0 à S16, à un circuit mémoire 20A, 20B, 20C, 20D, 20E, 20F, 20G d'étage inférieur au circuit mémoire 20H du dernier étage, et neuf entrées relatives au signal d'horloge CLK, aux entrées série SI0 à S16, et à une entrée série 7 « SI7 » pour configurer le dispositif de configuration du circuit mémoire 20H du dernier étage.

Les trous 212, 214, 216, 218, 220, 222, 224, et 226 sont pourvus d'un matériau électriquement conducteur, afin de rendre électriquement accessibles les entrées de la partie mémoire de chaque circuit mémoire et les entrées du dispositif de configuration de chaque circuit mémoire.

Les entrées sont court-circuitées en hauteur « Z » selon une des coordonnées à trois dimensions. Aucune technique de re-routage en métal n'est donc nécessaire pour la connexion.

Chaque circuit mémoire de l'empilement 20 comporte, au niveau du dispositif de configuration, deux entrées, dont une lui est dédiée pour sa configuration, accessibles depuis le haut de l'empilement 20, au travers d'une borne d'entrée électriquement conductrice correspondante.

Une première entrée, à savoir l'entrée relative au signal d'horloge CLK, est commune à l'ensemble des huit circuits mémoire 20A, 20B, 20C, 20D, 20E, 20F, 20G, 20H et accessible depuis l'extérieur de l'empilement 20, au niveau de leur dispositif de configuration respectif.

Une deuxième entrée, à savoir l'entrée série SI, est spécifique à chaque circuit mémoire au niveau de son dispositif de configuration et accessible depuis l'extérieur de l'empilement 20.

Ainsi, le circuit mémoire 20A inférieur ou du premier étage comporte l'entrée série 0 « SI0 », le circuit mémoire 20B du deuxième étage l'entrée série 1 « SI1 », le circuit mémoire 20C du troisième étage l'entrée série 2 « SI2 », le circuit mémoire 20D du quatrième étage l'entrée série 3 « S13 », le circuit mémoire 20E du cinquième étage l'entrée série 4 « SI4 », le circuit mémoire 20F du sixième étage l'entrée série 5 « SI5 », le circuit mémoire 20G du septième étage l'entrée série 6 « SI6 », et le circuit mémoire 20H du huitième et dernier étage l'entrée série 7 « SI7 ».

L'entrée série 7 « SI7 » spécifique devant être accessible uniquement du circuit mémoire 20H du dernier étage est desservie par la borne 228 d'entrée. C'est la raison pour laquelle le circuit mémoire 20H du dernier étage ne comporte pas, pour cette entrée série 7 « SI7 », de trou traversant ce circuit mémoire 20H.

Les huit circuits mémoire 20A, 20B, 20C, 20D, 20E, 20F, 20G, 20H sont de capacités individuelles mémoire identiques, par exemple de 1 Go. L'empilement 20 ainsi constitué peut avoir une capacité totale pouvant aller de 0 Go à 8 Go selon le nombre de circuits mémoire valides en fonctionnement et compris au sein de l'empilement.

Après avoir déterminé la capacité totale mémoire résultante, une information correspondante est écrite et mémorisée au sein d'une zone mémoire, ou page, particulière prédéfinie de la partie mémoire, par exemple la page « zéro », du premier circuit mémoire valide en partant de la partie inférieure d'un bloc mémoire résultant de l'empilement ainsi constitué.

Le bloc mémoire peut être mis dans un boîtier en utilisant, par exemple, un technique dite de liaison classique (ou « bounding » en langue anglaise), en laissant un accès physique aux entrées d'au moins la partie mémoire du circuit mémoire 20H supérieur. Le boîtier enfermant un empilement est prêt à être accouplé, par exemple, à un microprocesseur ou une unité logique de traitement ou autre, pour être utilisé en tant que bloc mémoire.

Selon le mode de réalisation présenté, la partie située à droite des pointillés relative aux dispositifs de configuration des circuits mémoire n'est pas laissée accessible depuis l'extérieur du bloc mémoire. Ainsi, aucune information relative à un identifiant attribué à un circuit mémoire compris au sein de l'empilement ni aucune information relative à un résultat du test de validité d'un circuit mémoire compris au sein de l'empilement n'est modifiable après sa configuration lors de sa fabrication. En d'autres termes, l'identifiant attribué à chaque circuit mémoire de même que la valeur du résultat du test de validité y associé, sont figés.

Il est clair, cependant, que, selon un autre mode de réalisation, la partie située à droite des pointillés relative aux dispositifs de configuration des circuits mémoire est laissée accessible depuis l'extérieur du bloc mémoire. Ainsi, une information relative à un identifiant attribué à un circuit mémoire compris au sein de l'empilement et/ou une information relative à un résultat du test de validité d'un circuit mémoire compris au sein de l'empilement est modifiable après sa configuration, c'est-à-dire de manière dynamique.

Comme présenté en relation avec la figure 3, chaque circuit mémoire 20A, 20B, 20C, 20D, 20E, 20F, 20G, 20H comporte, par exemple, une partie distincte de sa partie mémoire interne au circuit mémoire. Une telle partie distincte constitue un dispositif 30 de configuration du circuit mémoire au sein de l'empilement 20.

Le dispositif 30 de configuration du circuit mémoire comporte deux entrées, à savoir une première entrée 32 correspondant à un signal d'horloge « CLK » et une deuxième entrée 34 correspondant à une entrée série dédiée « Sli » au circuit mémoire, le « i » correspondant au rang du circuit mémoire concerné au sein de l'empilement 20.

Le dispositif 30 de configuration du circuit mémoire au sein de l'empilement comporte :
- un registre 36 à décalage série,
- un dispositif 310 d'écriture d'un mot d'état, et
- un espace mémoire 314 du mot d'état.

Le registre 36 à décalage série comporte quatre étages 36₁, 36₂, 36₃, et 36₄ à registre. Le nombre d'étages à registre est égal au nombre de bits nécessaires pour coder l'information relative à l'identifiant attribué au circuit mémoire au sein de l'empilement et l'information relative au résultat du test de validité du circuit mémoire.

Tel que connu en soi, la première entrée 32 dédiée au signal d'horloge est commune à l'ensemble des quatre étages 36₁, 36₂, 36₃, et 36₄ pour cadencer la mémorisation au sein du registre 36 à décalage série.

Outre l'entrée dédiée au signal d'horloge, chacun des trois premiers étages 36₁, 36₂, 36₃ comporte une entrée (représentée pour le premier étage seulement), une sortie reliée à l'étage 36₂, 36₃, et 36₄ qui lui succède (non représentée), et une autre sortie 316₁, 316₂, 316₃, et 316₄ qui fournit, la valeur du bit en entrée de l'étage concerné,.

A chaque nouvelle impulsion du signal d'horloge « CLK », la valeur située en entrée d'un étage est recopiée en sortie de l'étage en question, la valeur d'un bit d'un train de bits situé en entrée Sli se propage d'étage en étage au sein du registre 36 à décalage série.

Lors d'une première impulsion du signal d'horloge « CLK » (sur un front montant ou un front descendant), le premier étage 36₁ enregistre la valeur du premier bit d'un train de bits situé à l'entrée 34 Sli et la présente en sortie à disposition du deuxième étage 36₂ et sur son autre sortie 316₁.

A la deuxième impulsion du signal d'horloge « CLK », le deuxième étage 36₂ enregistre la valeur du premier bit du train de bits issu du premier étage 36₁ et la présente en sortie à disposition du troisième étage 36₃ et sur son autre sortie 316₂. Dans le même temps, le premier étage 36₁ enregistre la valeur du deuxième bit du train de bits provenant de l'entrée 34 Sli et la présente en sortie à disposition du deuxième étage 36₂ et sur son autre sortie 316₁.

A la troisième impulsion du signal d'horloge « CLK », le troisième étage 36₃ enregistre la valeur du premier bit du train de bits issu du deuxième étage 36₂ et la présente en sortie à disposition du quatrième étage 36₄ et sur son autre sortie 316₃. Dans le même temps, le deuxième étage 36₂ enregistre la valeur du deuxième bit du train de bits issu du premier étage 36₁ et la présente en sortie à disposition du troisième étage 36₃ et sur son autre sortie 316₂. En parallèle, le premier étage 36₁ enregistre la valeur du troisième bit du train de bits provenant de l'entrée 34 Sli et la présente en sortie à disposition du deuxième étage 36₂ et sur son autre sortie 316₁.

Au bout de la quatrième impulsion du signal d'horloge « CLK », le quatrième étage 36₄ enregistre la valeur du premier bit du train de bits issu du troisième étage 36₃ et la présente en sortie à disposition du quatrième étage 36₄ et sur son autre sortie 316₄. Dans le même temps, le troisième étage 36₃ enregistre la valeur du deuxième bit du train de bits issu du deuxième étage 36₂ et la présente en sortie à disposition du quatrième étage 36₄ et sur son autre sortie 316₃. Simultanément, le deuxième étage 36₂ enregistre la valeur du troisième bit du train de bits issu du premier étage 36₁ et la présente en sortie à disposition du troisième étage 36₃ et sur son autre sortie 316₂. En parallèle, le premier étage 36₁ enregistre la valeur du quatrième bit du train de bits provenant de l'entrée 34 Sli et la présente en sortie à disposition du deuxième étage 36₂ et sur son autre sortie 316₁.

Chaque étage du registre à décalage série est destiné à enregistrer temporairement une valeur binaire d'une partie du codage de l'information relative à l'identifiant attribué au circuit mémoire au sein de l'empilement ou du codage de l'information relative au résultat du test de validité du circuit mémoire.

De façon connu en soi, au moins un bit d'adresse mémoire est prévu pour adresser la partie mémoire de chaque circuit mémoire.

L'information relative à l'identifiant attribué au circuit mémoire au sein de l'empilement reflète le rang logique et/ou physique du circuit mémoire sous forme binaire. Une telle information est codée sur au moins un bit d'adresse s'ajoutant à ceux propre à l'adresse de la partie mémoire.

L'empilement 20 comportant huit étages de circuits mémoire, l'information relative à l'identifiant attribué au circuit mémoire est codée, par exemple, sur trois bits d'adresse supplémentaires.

Par exemple, au bout de quatre impulsions d'horloge, le premier étage 36₁ est destiné à enregistrer la valeur du troisième bit d'adresse A3, le deuxième étage 36₂ la valeur du deuxième bit d'adresse A2, et le troisième étage 36₃ la valeur du premier bit d'adresse A1.

L'information relative au résultat du test de validité du circuit mémoire concerné est codée sur au moins un bit.

Un seul bit peut suffire, par exemple, à coder le résultat du test de validité du circuit mémoire sauvegardé temporairement dans le dernier étage 36₄ du registre 36.

Par exemple, au bout de quatre impulsions d'horloge, le quatrième étage 36₄ est destiné à enregistrer la valeur du bit relatif au résultat du test de validité du circuit mémoire concerné. Par exemple, la valeur « 1 » signifie que le circuit mémoire en question est valide, tandis que la valeur « 0 » signifie que ce dernier est défectueux.

Le dernier étage 36₄ du registre 36 est connecté, au travers d'une entrée 38, au dispositif 310 d'écriture d'un mot d'état, afin de transmettre le signal d'horloge CLK.

Le dispositif 310 d'écriture d'un mot d'état est utilisé pour détecter la quatrième impulsion du signal d'horloge CLK. Le dispositif 310 d'écriture d'un mot d'état génère, au niveau d'une sortie 312 reliée à l'espace mémoire 314 du mot d'état, un signal reflétant la détection de la quatrième impulsion du signal d'horloge CLK.

L'espace mémoire 314 du mot d'état est, de préférence, une zone mémoire (ou page) particulière prédéfinie de la partie mémoire du circuit mémoire concerné. Une telle zone mémoire est dissociée de la partie mémoire du circuit mémoire destinée à être utilisée en fonctionnement, pour mémoriser des données issues de l'extérieur du circuit mémoire (compris au sein de l'empilement).

L'espace mémoire 314 du mot d'état comporte un nombre de cellules 314₁, 314₂, 314₃, et 314₄ mémoire égal au nombre d'étages compris au sein du registre à décalage série. Les cellules 314₁, 314₂, 314₃, et 314₄ mémoire sont reliées, au niveau d'une entrée dite de validation, à la sortie 312 du dispositif 310 d'écriture d'un mot d'état. Chaque cellule 314₁, 314₂, 314₃, ou 314₄ mémoire est également reliée, via une entrée respective, à la sortie 316₁, 316₂, 316₃, ou 316₄ d'un étage 36₁, 36₂, 36₃ et 36₄ correspondant du registre 36 à décalage série. Chaque cellule 314₁, 314₂, 314₃, ou 314₄ mémoire est adaptée pour recopier, lors de la génération du signal de validation issu en sortie 312 du dispositif 310 d'écriture d'un mot d'état lors de la détection de la quatrième impulsion du signal d'horloge CLK, la valeur binaire disponible sur une entrée reliée à la sortie de l'étage 316₁, 316₂, 316₃, ou 316₄ correspondant du registre 36 à décalage série.

Chaque cellule 314₁, 314₂, 314₃, ou 314₄ mémoire est prévue pour mémoriser une valeur binaire constituant soit une partie de l'information relative à l'identifiant attribué au circuit mémoire au sein de l'empilement soit une partie de l'information relative au résultat du test de validité du circuit mémoire concerné.

Lors de la détection de la quatrième impulsion du signal d'horloge CLK, la première cellule 314₁ mémorise la valeur du troisième bit de l'adresse supplémentaire A3, la deuxième cellule 314₂ la valeur du deuxième bit de l'adresse supplémentaire A2, la troisième cellule 314₃ la valeur du premier bit de l'adresse supplémentaire A1 du circuit mémoire concerné, et la quatrième cellule 314₄ la valeur du bit de validité ou de non-validité de la mémoire du circuit mémoire concerné.

Les quatre cellules 314₁, 314₂, 314₃, et 314₄ mémoire mémorisent le mot d'état et constituent, par exemple, quatre mémoires tampon sauvegardant chacune sa valeur. De préférence, ces quatre cellules 314₁, 314₂, 314₃, et 314₄ mémoire sont figées une fois la phase de configuration finie. Les quatre cellules 314₁, 314₂, 314₃, et 314₄ mémoire constituent, par exemple, quatre cellules Flash non-volatiles.

Le mot d'état est donc constitué de quatre bits constituant une information pour adresser le circuit mémoire, de manière supplétive, par rapport aux bits d'adressage classiques du circuit mémoire.

La valeur d'un bit V de validité ou de non-validité de la mémoire du circuit mémoire en question est utilisée pour sélectionner ou, au contraire, ne pas sélectionner le circuit mémoire concerné.

Un tel dispositif de configuration de chaque circuit mémoire au sein de l'empilement constitue une circuiterie logique additionnelle simple.

Selon une alternative de réalisation, le dispositif de configuration de chaque circuit mémoire au sein de l'empilement est basé sur un circuit à base de fusibles. Le nombre de fusibles est, par exemple, égal au nombre de bits nécessaires pour coder l'information relative à l'identifiant attribué au circuit mémoire au sein de l'empilement et l'information relative au résultat du test de validité du circuit mémoire. Un fusible électriquement fermé correspond, par exemple, à la valeur binaire « 0 », tandis qu'un fusible électriquement ouvert correspond à la valeur binaire « 1 ». Bien entendu, selon une autre réalisation, une convention inverse peut être adoptée, à savoir le fusible fermé correspond à la valeur binaire « 1 » et le fusible ouvert correspond à la valeur binaire « 0 ».

De plus, chaque circuit mémoire comporte, outre un comparateur d'adresse (non représenté) propre à sa partie mémoire, un comparateur d'adresse (non représenté) propre à sa partie configuration et relative au(x) bit(s) d'adresse supplémentaire(s) relevant de l'information relative à l'identifiant attribué au circuit mémoire concerné au sein de l'empilement.

De manière avantageuse, les informations relatives aux identifiants attribués aux circuits mémoire valides d'un même empilement lors de leurs configurations sont prévues de valeurs continues. C'est-à-dire que deux circuits mémoire valides en fonctionnement et physiquement les plus proches au sein de l'empilement ont des identifiants de valeurs consécutives. En d'autres termes, deux circuits mémoire valides éventuellement séparés par un ou des circuits mémoire non valides sont adressables de manière continue, à savoir sans trou ou discontinuité d'adressage. Dès qu'il existe au moins un circuit mémoire valide en fonctionnement, l'empilement de circuits mémoire forme un plan d'adressage continu du ou des circuits mémoire testés valides en fonctionnement, quel que soit le nombre de circuits mémoire non valides en fonctionnement de l'empilement considéré.

Le mot d'état est écrit au sein de chaque dispositif de configuration d'un circuit mémoire de l'empilement lors d'une phase de configuration, par exemple, lors d'un test final de validité de l'empilement. Le test final s'effectue, par exemple, à l'aide d'un scan logique de l'espace mémoire ainsi formé au sein de l'empilement.

L'information stockée au sein du testeur ou accessible depuis le testeur, selon laquelle le circuit mémoire est bon ou mauvais en fonctionnement et le rang du circuit mémoire occupé au sein de l'empilement est écrite.

Par exemple, le circuit mémoire 20A du premier étage (en partant du bas) de l'empilement est configuré, en utilisant l'entrée série 0 « SI0 » d'un bus série constitué des entrées série SI0 à SI7, après quatre impulsions d'horloge, à l'aide d'un quartet « A3A2A1V », où le bit V de validité représente le poids le plus faible du quartet. Si la mémoire du circuit mémoire du premier étage est valide, alors le quartet « 0001 » dans cet ordre est écrit, lors d'une première écriture, dans quatre cellules mémoire du dispositif de configuration du circuit mémoire 20A du premier étage. Si la mémoire du circuit mémoire du premier étage est non-valide, alors le quartet « 0000 » dans ce même ordre est écrit lors d'une première écriture dans quatre cellules mémoire du dispositif de configuration du circuit mémoire 20A du premier étage.

Il est à noter que, lors de la configuration du dispositif de configuration du circuit mémoire du premier étage, les sept autres dispositifs de configuration propres aux sept autres circuits mémoire de l'empilement sont, dans un même temps, également impactés en écriture. Cependant, les sept valeurs de quartet écrites dans les dispositifs de configuration correspondants seront écrasées et remplacées par la suite lors de leurs configurations respectives.

Ensuite, le circuit mémoire 20B du deuxième étage de l'empilement est, à son tour, configuré, en utilisant l'entrée série 1 « SI1 » du bus série, après quatre impulsions d'horloge, à l'aide d'un quartet « A3A2A1V », où le bit V de validité représente le poids le plus faible du quartet. Si la mémoire du circuit mémoire 20B du deuxième étage est valide et la mémoire du circuit mémoire 20A du premier étage est valide, alors le quartet « 0011 » dans cet ordre est écrit, lors d'une deuxième écriture, dans quatre cellules mémoire du dispositif de configuration du circuit mémoire 20B du deuxième étage.

Si la mémoire du circuit mémoire du premier étage est non-valide et la mémoire du circuit mémoire 20A du premier étage est valide, alors le quartet « 0010 » dans ce même ordre est écrit lors d'une deuxième écriture. Lors de la deuxième écriture du quartet au sein du dispositif de configuration du circuit mémoire 20B du deuxième étage, le quartet configuré précédemment lors de la première écriture est mis à jour avec le quartet écrit à l'aide de la deuxième écriture. Le quartet écrit lors de la première écriture au sein du dispositif de configuration du circuit mémoire 20A du premier étage reste inchangé, et donc égal au quartet « 0001 ».

Si, en revanche, la mémoire du circuit mémoire 20A du premier étage est non valide et la mémoire du circuit mémoire 20B du deuxième étage est valide, alors le quartet « 0000 » est confirmé au sein des quatre cellules mémoire du dispositif de configuration du circuit mémoire 20B du deuxième étage. En effet, le circuit mémoire 20B du deuxième étage constitue la première adresse valide d'un circuit mémoire valide en partant du bas de l'empilement.

Et, on continue ainsi, pour la configuration des circuits mémoire situés au dessus des circuits mémoire de premier et deuxième étages de l'empilement.

Selon un mode de réalisation préférentiel de chaque dispositif de configuration d'un circuit mémoire prévu au sein de l'empilement, le dispositif de configuration est inopérant en mode fonctionnel, c'est-à-dire qu'il n'est pas accessible électriquement pour changer la valeur du mot d'état écrit dans ses propres cellules mémoire. Pour ce faire, toute entité externe, telle un microprocesseur ou une unité de traitement logique, reliée électriquement à la partie mémoire de chaque circuit mémoire de l'empilement n'est pas câblée à la partie configuration du circuit mémoire concerné. Bien entendu, la valeur du mot écrit reste accessible en lecture depuis l'extérieur de l'empilement.

Selon un autre mode de réalisation, chaque dispositif de configuration d'un circuit mémoire prévu au sein de l'empilement est également opérant en mode fonctionnel, c'est-à-dire qu'il est électriquement accessible pour changer, de manière dynamique, la valeur du mot d'état écrite dans ses propres cellules mémoire. Pour ce faire, toute entité externe, telle un microprocesseur ou une unité de traitement logique, reliée électriquement à la partie mémoire de chaque circuit mémoire de l'empilement est également reliée à la partie configuration du circuit mémoire concerné. Un tel autre mode de réalisation s'avère avantageux pour un empilement dont au moins un circuit mémoire qui le compose devient invalide, par exemple, suite à une trop grande sollicitation en écriture et/ou en lecture. Selon un tel mode de réalisation, dès qu'une mémoire d'un circuit mémoire devient invalide, la signature électronique de l'empilement est également mise à jour avec une valeur correspondant à la somme des espaces mémoire des circuits mémoire de l'empilement restant valides. Selon un tel mode, un trou d'adressage apparaît pour l'entité externe reliée à l'empilement qui doit en tenir compte de manière logicielle, en opérant notamment une traduction d'adresse, et en gérant chaque circuit mémoire détecté invalide en mode fonctionnel en ne les adressant plus.

Il est ainsi attribué au premier circuit mémoire valide au sein de l'empilement 20, en partant du bas d'un empilement donné, la valeur binaire d'adressage « 000 », et la valeur « 1 » pour sa validation.

Grâce à un tel mode d'adressage constitué par les trois bits d'adresse supplémentaires complétés d'un bit de validation, il est possible d'isoler tout circuit mémoire défectueux composant l'empilement, et donc de ne pas l'adresser.

Il est à noter que si tous les circuits mémoire de l'empilement sont valides, alors le rang logique du circuit mémoire correspond à son rang physique au sein de l'empilement lorsque l'on observe les bits d'adresse supplémentaires.

On comprend qu'une fois configurés, les circuits mémoire de l'empilement 20, seul(s) le ou les circuits mémoire référencés comme étant valides pour leur partie mémoire sont adressés pour accéder à leurs parties mémoire respectives.

Pour adresser un circuit mémoire au sein de l'empilement, une information d'adresse est, d'abord, en fonctionnement, comparée à une information relative à l'identifiant attribué au circuit mémoire au sein de l'empilement constituée par la valeur des trois bits d'adresse supplémentaires A3A2A1.

Puis, si l'information d'adresse correspond à l'information relative à l'identifiant attribué au circuit mémoire au sein de l'empilement, une information relative au résultat du test de validité du circuit mémoire constituée par la valeur du bit supplémentaire V est lue.

Si la valeur du bit supplémentaire V lue correspond à celle attribuée à une partie mémoire valide pour le circuit mémoire sélectionné, alors on autorise l'accès à une adresse quelconque de l'espace mémoire du circuit mémoire sélectionné et identifié par la valeur des trois bits d'adresse supplémentaires A3A2A1 qui lui ont été affectés.

Dans le cas contraire, c'est-à-dire si la valeur du bit supplémentaire V lue correspond à celle attribuée à une partie mémoire non valide pour le circuit mémoire sélectionné, alors on interdit l'accès à une adresse quelconque de l'espace mémoire du circuit mémoire sélectionné et identifié par la valeur des trois bits d'adresse supplémentaires A3A2A1 qui lui ont été affectés.

Dans un tel cas, le circuit mémoire repéré par son identifiant est référencé comme étant non valide ou mauvais, c'est-à-dire que la partie mémoire en tant que telle ne fonctionne pas, il n'est pas possible de sélectionner un tel circuit mémoire. L'adressage de la partie mémoire non valide du circuit mémoire est interdit en lecture et/ou en écriture. Il est alors impossible d'accéder à sa partie mémoire lorsqu'elle est défectueuse, ni pour une lecture ni pour une écriture.

## Revendications

1. Procédé (10) pour fabriquer un empilement de circuits mémoire, le procédé comprenant une étape (14) de test de validité d'au moins deux circuits mémoire,
**caractérisé en ce que** le procédé comprend une phase (18) de configuration de chaque circuit mémoire, la phase de configuration comportant une étape (110) d'écriture, au sein d'un dispositif de configuration de chaque circuit mémoire compris au sein de l'empilement, d'une information relative à un identifiant attribué au circuit mémoire au sein de l'empilement et d'une information relative à un résultat du test de validité du circuit mémoire.

2. Procédé selon la revendication 1, dans lequel au moins deux circuits mémoire de l'empilement sont issus d'au moins deux tranches distinctes, chaque tranche comprenant au moins deux circuits mémoire.

3. Procédé selon la revendication 2, dans lequel le procédé comprend une phase (12) de préparation de chaque tranche, la phase de préparation comprenant une étape (16) de perçage de chaque circuit mémoire, au niveau du dispositif de configuration du circuit mémoire.

4. Procédé selon la revendication 3, dans lequel l'étape (16) de perçage de chaque circuit mémoire consiste à percer, au niveau de son dispositif de configuration, au moins un trou, au niveau d'au moins une entrée dédiée :
- à l'information relative à l'identifiant attribué au circuit mémoire au sein de l'empilement, et
- à l'information relative au résultat du test de validité du circuit mémoire.

5. Procédé selon la revendication 4, dans lequel le perçage du circuit mémoire au niveau du dispositif de configuration est fonction d'un rang du circuit mémoire occupé au sein de l'empilement.

6. Procédé selon l'une des revendications 1 à 5, dans lequel le procédé comprend une étape (112) d'écriture, au sein d'une adresse mémoire prédéterminée, d'un circuit mémoire compris au sein de l'empilement et dont le résultat du test de validité correspond à un état valide, d'une information relative à une capacité mémoire totale relative à l'ensemble du ou des circuits mémoire compris au sein de l'empilement et dont le résultat individuel du test de validité correspond à un état valide.

7. Procédé selon l'une des revendications 2 à 6, dans lequel le procédé comprend au moins certaines des phases appartenant au groupe comprenant :
- une phase de superposition de circuits mémoire d'au moins deux tranches au droit d'au moins un trou formé au sein de chaque circuit mémoire au niveau du dispositif de configuration,
- une phase de solidarisation desdites au moins deux tranches,
- une phase de remplissage, à l'aide d'un matériau électriquement conducteur, d'au moins un trou formé au sein de chaque circuit mémoire,
- une phase de découpe desdites au moins deux tranches, la phase de découpe permettant de séparer au moins deux empilements de circuits mémoire.

8. Procédé pour adresser un circuit mémoire au sein d'un empilement de circuits mémoire,
**caractérisé en ce que** le procédé comprend :
- une étape de comparaison, au niveau d'un dispositif de configuration du circuit mémoire au sein de l'empilement, d'une information d'adresse à une information relative à un identifiant attribué au circuit mémoire au sein de l'empilement, et
- dans l'hypothèse où l'information d'adresse correspond à l'information relative à l'identifiant attribué au circuit mémoire, une étape de lecture d'une information relative à un résultat d'un test de validité du circuit mémoire.

9. Procédé selon la revendication 8, dans lequel le procédé comprend, en fonction de l'information relative au résultat du test de validité du circuit mémoire, une étape d'autorisation ou d'interdiction d'accès à une information stockée au sein du circuit mémoire correspondant au circuit mémoire identifié par l'identifiant.

10. Empilement (20) de circuits mémoire comprenant au moins deux circuits (20A, 20B, 20C, 20D, 20E, 20F, 20G, 20H) mémoire empilés l'un sur l'autre,
**caractérisé en ce que** chaque circuit mémoire comporte un dispositif (30) de configuration du circuit mémoire au sein de l'empilement, le dispositif de configuration comprenant des moyens (36, 310, 314) pour stocker :
- une information relative à un identifiant attribué au circuit mémoire au sein de l'empilement, et
- une information relative à un résultat d'un test de validité du circuit mémoire.

11. Empilement selon la revendication 10, dans lequel l'information relative à l'identifiant attribué au circuit mémoire au sein de l'empilement est codée sur au moins un bit d'adresse supplémentaire.

12. Empilement selon l'une des revendications 10 et 11, dans lequel l'information relative au résultat du test de validité du circuit mémoire est codée sur au moins un bit.

13. Empilement selon la revendication 12, elle-même dépendante de la revendication 11, dans lequel le dispositif de configuration comporte au moins une entrée dédiée à l'information relative à l'identifiant attribué au circuit mémoire au sein de l'empilement et à l'information relative au résultat du test de validité du circuit mémoire.

14. Empilement selon la revendication 13, dans lequel le dispositif de configuration comporte un espace mémoire d'un mot d'état, l'espace mémoire du mot d'état étant destiné à stocker l'information relative à l'identifiant attribué au circuit mémoire au sein de l'empilement et l'information relative au résultat du test de validité du circuit mémoire.

15. Empilement selon la revendication 13, dans lequel le dispositif de configuration comporte au moins deux fusibles, le nombre de fusibles étant égal au nombre de bits nécessaires pour coder l'information relative à l'identifiant attribué au circuit mémoire au sein de l'empilement et l'information relative au résultat du test de validité du circuit mémoire, un fusible passant correspondant à une valeur de bit prédéterminée, un fusible ouvert correspondant à l'autre valeur de bit.

16. Empilement selon l'une des revendications 10 à 15, dans lequel chaque circuit mémoire de l'empilement comporte au moins un comparateur d'adresse par rapport à l'information relative à l'identifiant attribué au circuit mémoire au sein de l'empilement.

17. Dispositif électronique comprenant au moins un bloc mémoire,
**caractérisé en ce que** ledit au moins un bloc mémoire comporte au moins un empilement selon l'une des revendications 10 à 16.
